# EUROPEAN PATENT APPLICATION

(11) **EP 0 801 328 A1**
(43) Date of publication of application: **15.10.1997**
(21) Application number: 97302176.9
(22) Date of filing: 27.03.1997
(51) Int. Cl.: G03F 7/031, G03F 7/027

(54) **Photoimageable composition having an acrylic-functional UV stabilizer**

(30) Priority: 09.04.1996 US 631293
(71) Applicant: MORTON INTERNATIONAL, INC., Chicago Illinois 60606-1596 (US)
(72) Inventor: Barr, Robert K., Laguna Niguel, California 92677 (US); Nguyen, Trang D., Fountain Valley, California 92708 (US)
(74) Representative: Bankes, Stephen Charles Digby

(57) **Abstract**

A negative-acting photoimageable composition including a photopolymerizable compound(c), a binder polymer and a free-radical generating chemical system is improved by the inclusion of an acrylic functional U.V. stabilizer either incorporated in the binder polymer and/or as a portion of the photopolymerizable compounds and the use of phenyl acridine as at least a portion of the free-radical generating chemical system.

## Description

The present invention is directed to negative-acting photoimageable compositions, such as those used as primary photoresists or solder mask-forming compositions. The photoimageable composition contains a UV stabilizer having acrylate functionality.

This invention is generally directed to negative-acting photoimageable compositions. The photoimageable compositions may be either primary photoresists or photoimageable compositions useful for forming hard, permanent masks, such as solder masks. The photoimageable compositions may be solvent-developable or developable in aqueous or semi-aqueous solutions.

A photoimageable composition (negative-acting) contains a photopolymerizeable or photo cross-linkable substance. In most cases, the primary photopolymerizeable material is a monomer or mixture of monomers. The photopolymerizeable material also may be or may include dimers or short-chain oligomers. In connection with photopolymerizeable monomers dimers and short-chain oligomers, it is the usual practice to provide a binder comprising pre-formed polymeric material. The binder polymeric material may or may not have functionality so that it enters into the polymerizeable reaction. Less commonly, a pre-formed polymeric material may serve as a binder and be photo cross-linkable. In order to harden the film by photopolymerization or photo cross-linking, the photoimageable composition further contains a radiation-sensitive free-radical generating system activatable by actinic radiation.

In the photo-hardening process, radiation is normally absorbed to provide the initiating species. The amount of radiation available for the production of initiating species will, therefore, decrease progressively from the surface downwards. In the deeper layers of the composition, hardening will be correspondingly less rapid. At the same time, radiation will be scattered into non-illuminated areas by the film and by reflection from the substrate, thus initiating hardening in those areas, resulting in line growth. Line growth is particularly problematic when an exposed resist line is adjacent a large exposed area known as a "land area" or "pad".

To limit line growth, it is known to add U.V. stabilizers to such photoimageable compositions. One significant problem with common U.V. stabilizers is that they are generally low in molecular weight and tend to leach into the various chemistries used for the subsequent manufacture of circuit boards. For example, U.V. stabilizers may leach into and foul a plating bath.

In accordance with the present invention, in a negative-acting photoimageable composition comprising A) an addition-polymerizable, nongaseous ethylenically unsaturated compound(s) capable of forming a high polymer by free-radical initiated chain-propagating addition polymerization, B) an organic polymeric binder and C) an organic, radiation-sensitive free-radical generating system activatable by actinic radiation to initiate chain-propagating addition polymerization of the addition-polymerizable material, the improvement is the use of phenyl acridine as all or part of the free-radical generating system C) and the use of an acrylic-functional U.V. stabilizer, either incorporated in the organic binder polymer B) and/or as a portion of the ethylenically unsaturated compounds A), the acrylic-functional U.V. stabilizer having the formula: 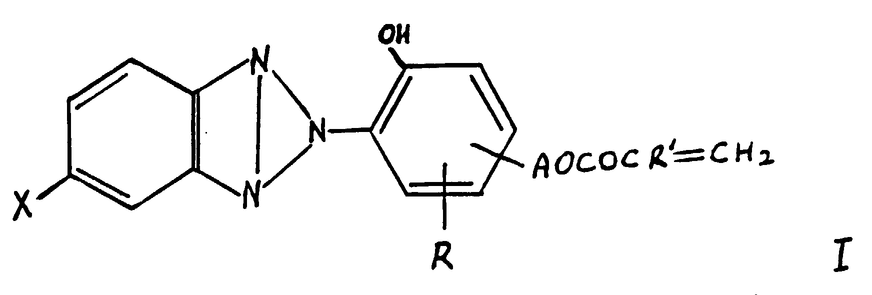 wherein X is hydrogen or a halogen, R is C₁-C₁₀-alkyl, R¹ is hydrogen or methyl, and A is C₁-C₁₀-alkyl.

Herein, unless otherwise noted, all percentages are weight percentages. Components A) (the photopolymerizable material), Component B) (the binder polymer) and Component C) (the photoinitiator chemical system) are herein considered to equal 100 wt%, and other components are calculated as parts relative to 100 parts of A) plus B) plus C).

As all negative-acting photoimageable compositions having an ethylenically unsaturated, photopolymerizable material and a free-radical chemical generating system are susceptible to undesirable line growth as discussed above, the inclusion of an acrylic-functional U.V. stabilizer and phenyl acridine as a photoinitiator is generally applicable to such compositions.

The invention is particularly applicable to photoimageable compositions which are developable in alkaline aqueous solution and which therefore have substantial acid functionality. Such photoimageable compositions typically have a binder having acid functionality, typically an acid number of at least about 80, preferably at least about 100 and more preferably about 150 or more, up to about 250. The acid functionality is typically carboxylic acid functionality, but may also include, for example, sulfonic acid functionality or phosphoric acid functionality.

The polymers are typically derived from a mixture of acid functional monomers and non-acid functional monomers. Some specific examples of suitable acid functional monomers are acrylic acid, methacrylic acid, maleic acid, fumaric acid, citraconic acid, 2-acrylamido-2-methylpropanesulfonic acid, 2-hydroxyethyl acrylolyl phosphate, 2-hydroxypropyl acrylol phosphate, 2-hydroxy-alpha-acryloyl phosphate, etc. One or more of such acid functional monomers may be used to form the binder polymer.

The acid functional monomers may be copolymerized with non-acid functional monomers, such as esters of acrylic acids, for example, methyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl) -propane dimethacrylate, triethylene glycol diacrylate, polyoxyethyl-2-2-di(p-hydroxyphenyl) -propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

Examples of such polymers and photoimageable compositions using such polymers are found, in the following U.S. Patents: 4,615,950; 3,359,129; 3,526,504; 3,980,483; 4,025,407; 4,210,449; 4,260,675; 4,268,614; 4,289,845; 4,413,052; 4,451,523; 4,465,760; 4,528,261; 4,296,196; 4,361,640; 4,250,248; 3,953,309; 3,376,138; and 4,239,849, the teaching of each of which are incorporated herein by reference.

The photopolymerizable component is typically a monomer, dimer or short chain oligomer having ethylenic unsaturation, particularly alpha,beta-ethylenic unsaturation. Particularly suitable are compounds having alpha,beta-ethylenic unsaturation of functionality 2 or greater as such higher acrylic functionality provides a cross-linked structure upon photopolymerization. Suitable photopolymerizable compounds include, but are not limited to, the monomers recited above as suitable for forming binder polymers, particularly the non-acid functional compounds.

In accordance with the invention, U.V. stabilization is provided by incorporation of the acrylic-functional U.V. stabilizer of the formula identified above, either incorporated as copolymerized units of the binder polymer B) and/or as a portion of the photopolymerizable material A). For U.V. stabilization, it makes little difference whether the acrylic-functional U.V. stabilizer is part of the binder polymer B) or the photopolymerizable material A). Also, because the aforementioned problems of U.V. stabilizer leaching is generally a post exposure and development problem, e.g., in plating baths, it makes little difference whether the acrylic-functional U.V. stabilizer is in the binder B) or photpolymerizeable material A). In either case, after photopolymerization and development, the acrylic-functional U.V. stabilizer is tied up in a polymeric structure where it cannot leach during subsequent processing. On the other hand, it may be most convenient to provide the acrylic-functional U.V. stabilizer as part of the photopolymerizable material A), allowing the continued use of known binder polymers, including commercially available binder polymers. A commercially available acrylic-functional U.V. stabilizer is sold as Norblock® by Noramco, Inc, New Brunswick, NJ and has the formula: 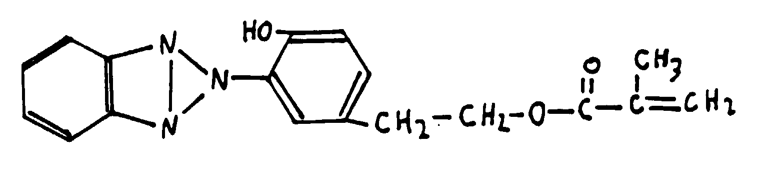 To be effective in reducing line growth, the acrylic-functional U.V. stabilizer is used at a total level of between about 0.05 and about 5 wt% of the total of the solids of A) plus B) plus C).

To initiate polymerization of the monomers upon exposure to actinic radiation, the photoimageable composition contains an appropriate photoinitiator(s) or photoinitiator chemical system. The photoinitator used in accordance with the present invention is phenyl acridine, either as the only photoinitiator or in conjunction with other photoinitiating species. Phenyl acridine is used in accordance with the present invention at levels of 0.05 to 5 wt% of the total solids of A) plus B) plus C). Phenyl acridine is used as the only photoinitiator or in conjunction of other photoinitiators known in the art, such as benzoin ethers, benzil ketals, acetophenones, benzophenones and related compounds with amines.

While the acrylic-functional U.V. stabilizers described herein very adequately address the leaching problem common to U.V. stabilizers, they tend to have a detrimental affect on photospeed of the photoimageable composition. This, however, is addressed by the use of the acrylic functional U.V. stabilizer in conjunction with phenyl acridine, which is a very fast photoinitiator. In fact, phenyl acridine is such an effective photoinitiator that it may be avoided in compositions of the type to which the present invention is directed because it tends to promote line growth. Herein, it is found that when using the above-described acrylic-functional U.V. stabilizer in conjunction with phenyl acridine as the photoinitiator, photoimageable compositions have good photospeed, minimal line-growth, and no leaching of U.V. stabilizers in post-development processing.

Because the invention is applicable to a wide variety of photoimageable compositions, the relative percentages of the binder polymer, the monomer(s) and photoinitiator may vary over a wide range. The carboxyl-containing binder polymer B) may typically comprise between about 30 and about 80 wt. percent of A) plus B) plus C), the photopolymerizable compounds B) (excluding the binder polymer if it so functions) typically comprises between about 15 and about 65 wt. percent of A) plus B) plus C) and the photoinitiator may comprise between about 0.05 and about 15 wt. percent of A) plus B) plus C).

Additionally, the photoimageable compositions may contain a wide variety of additional components as are known in the art, including additional polymers, such as those which might be used to effect a final hardened cure of a solder mask, dyes, stabilizers, flexibilizing agents, fillers etc.

While the above description of an alkaline aqueous-developable photoimageable composition is typical, a wide variety of alternatives have been proposed. In some cases, for example, the binder polymer may have ethylenic unsaturation which enters into the free-radical photopolymerization reaction, and in some cases the binder, having sufficient ethylenic unsaturation, may be used without additional photopolymerizable monomer or short chain oligomer. Regardless of the specific formulation of the photoimageable composition, the composition may advantageously incorporate the acrylic-functional U.V. stabilizer and photoinitiator combination of the present invention to provide reduced line growth while maintaining good photospeed.

Processing is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

The invention will now be described in greater detail by way of specific examples.

### Examples 1-6 (Examples 1-2 and 4-6 comparative)

A base formulation is prepared having the following components:

| Component | | Component function | Parts* |
|---|---|---|---|
| Ethyoxylated TMPTA** | | Multi-functional acrylate | 42.5 |
| Acrylic polymer*** | | Binder polymer | 56.6 |
| Modaflow® | | Flow control agent | 0.14 |
| Baso Blue 688 | | Background dye | 0.09 |
| Benzotriazole | | Adhesion promoter | 0.14 |

| | | | |
|---|---|---|---|
| *Parts calculated so that total of binder B), photopolymerizable material including multi-functional acrylate plus acrylic-functional U.V. stabilizer A) and phenyl acridine C) in Example 3 in accordance with the invention = 100% | | | |
| **Ethoxylated trimethylolpropanetriacrylate | | | |
| ***Ethyl acrylate/methyl methacrylate/methacrylic acid terpolymer having an acid number of 150. | | | |

To the base formula was added the following components

| Component | Function | Ex.1 | Ex.2 | Ex.3 | Ex.4 | Ex.5 | Ex.6 |
|---|---|---|---|---|---|---|---|
| Base Formula | | 99.1 | 99.1 | 99.1 | 99.1 | 99.1 | 99.1 |
| Quantacure ITX | thioxanthone photoinitiator | 0.7 | 0.7 | | | 0.7 | |
| Quantacure QEPD | tertiary amine photoinitiator | 2.1 | 2.1 | | | 2.1 | |
| Phenyl acridine | photoinitiator | | | 0.2 | 0.2 | | 0.2 |
| Norblock 7966 | acrylic-funct. U.V. stabilizer | 0.7 | | 0.7 | | | |
| Tinuvin 765 | non-acrylic U.V. stabilizer | | 0.7 | | 0.7 | | |

The resist lacquer at approximately 50% solids in methylethylketone was applied as a wet coating onto a polyester support film and dried to remove the solvent. After drying, to achieve a 1.5 mil thick resist layer, a polyethylene cover sheet was applied trapping the dry resist between the polyethylene and polyester. This material was then used for the first step of circuit production which is lamination.

Prior to lamination, the polyethylene cover sheet was removed and the resist containing this invention was laminated to a copper substrate with heat (95 to 120°C) and pressure (2 to 5 bar). Selected portions of the resist were then exposed to UV radiation rendering those areas insoluble in mild alkaline solutions. (Note: since certain areas are masked off from exposure, a dark reaction in those areas or on the fringe of those areas is unacceptable. The Norbloc helps to hinder that undesired reaction. Because circuit board geometries are getting smaller and smaller, inhibiting the dark reactions is more and more important).

The unexposed areas of resist was removed (developed) in 1% sodium carbonate monohydrate at 27 to 35°C. Where the resist was removed, 1 to 2 mils of copper was plated followed by a flash plate of Sn or SnPb (Sn and SnPb are used a temporary etch resists in an alkaline etch environment.) The exposed resist which was not developed from the board had to be chemically resistant to the various plating and precleaning chemicals present in the plating operation. (Also note, the exposed resist should not leach organics into the copper, tin and tin/lead plating bathes. Organics in plating baths drop their efficiency and require more frequent maintenance (carbon treatment). That is the main advantage of the Norbloc not leaching into the bath).

Once the channel had been plated, the exposed resist was stripped from between the copper plating in 3% NaOH at 130°F. As the final step, the boards were etched in alkaline etcher (alkaline etcher etches copper but does not etch Sn or SnPb). After etching, the Sn or SnPb was stripped from the panel in strong acids and the copper plated lines became the circuit board.

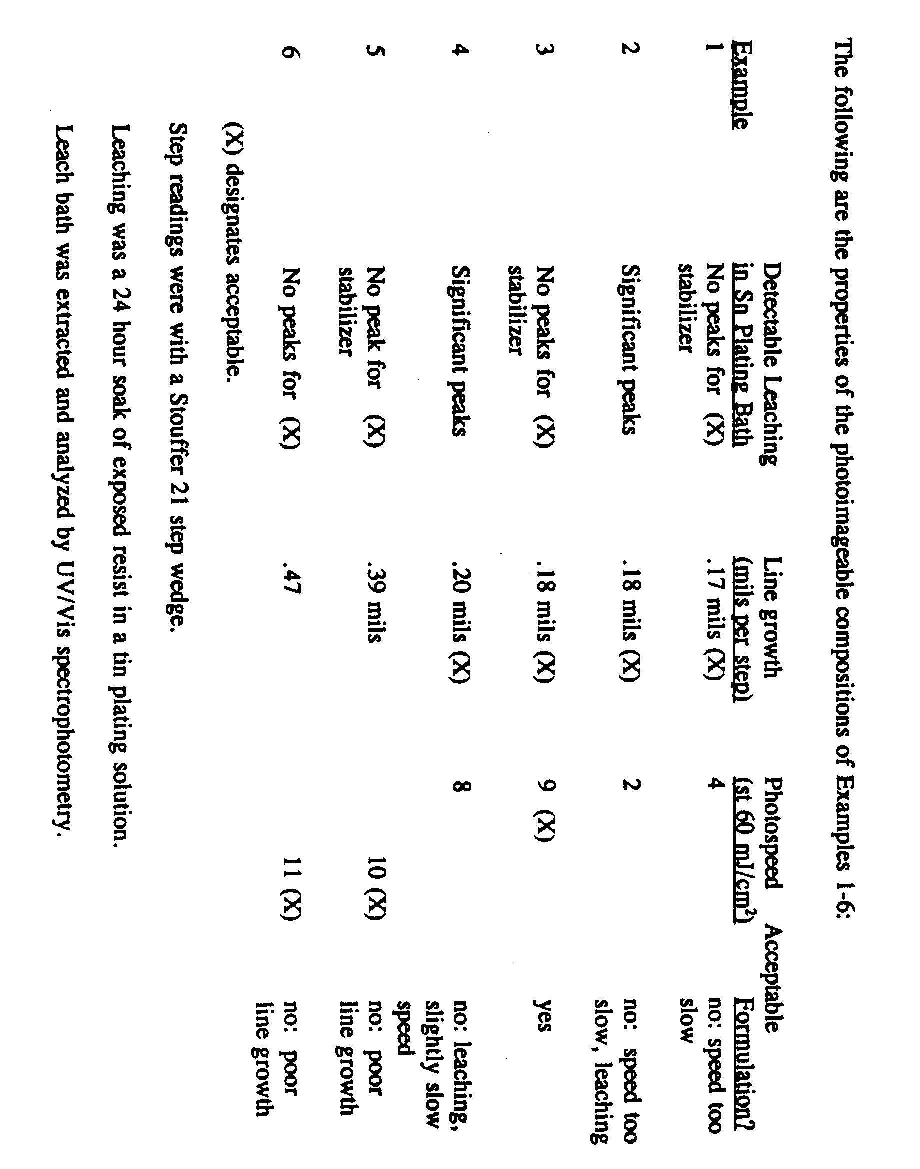

## Claims

1. A negative-acting photoimageable composition comprising:
(A) an addition-polymerizable, nongaseous ethylenically unsaturated compound capable of forming a high polymer by free-radical initiated chain-propagating addition polyymerization,
(B) an organic polymeric binder, and
(C) an organic, radiation-sensitive free-radical generating system activatable by actinic radiation to initiate chain-propagating addition polymerization of the addition-polymerizable compound,
characterised in that said composition incorporates between 0.05 and 5 wt.%, based on total solids weight of (A) plus (B) plus (C), of an acrylic-functional U.V. stabilizer, incorporated in (B) and/or as a portion of (A), and said composition incorporates, as all or a portion of (C), phenyl acridine at levels of between 0.05 and 5 wt% based on total weight of (A) plus (B) plus (C).

2. A negative-acting photoimageable composition according to claim 1 wherein the acrylic-functional U.V. stabilizer has the general formula: 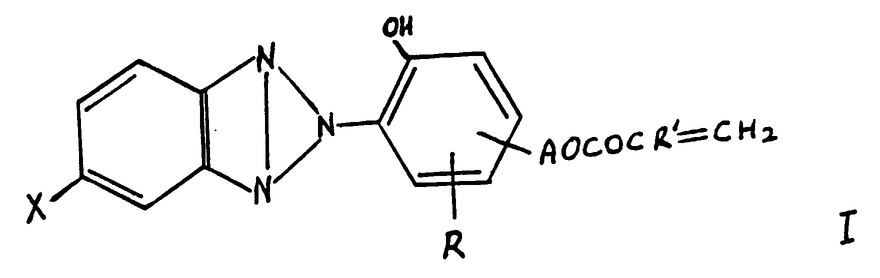 wherein X is hydrogen or a halogen, R is hydrogen or C₁-C₁₀-alkyl, R¹ is hydrogen or methyl, and A is a C₁-C₁₀-alkylene group.

3. A negative-acting photoimageable composition according to claim 2 wherein the acrylic-functional U.V. stabilizer has the general formula:
